# EUROPEAN PATENT APPLICATION

(11) **EP 4 235 761 A1**
(43) Date of publication of application: **30.08.2023**
(21) Application number: 22158545.8
(22) Date of filing: 24.02.2022
(51) Int. Cl.: H01L 21/683, H01L 21/687

(54) **SUBSTRATE HANDLING DEVICE FOR HANDLING A SUBSTRATE**

(71) Applicant: Semsysco GmbH, 5020 Salzburg (AT)
(72) Inventor: GLEISSNER, Andreas, 9873 Döbriach (AT); HOFAUER, Josef, 4882 Oberwang (AT)
(74) Representative: Maiwald GmbH

(57) **Abstract**

The disclosure relates to a substrate handling device 11 for handling a substrate 1, a substrate handling system 10, a use of the substrate handling device 11 or the substrate handling system 10 and a substrate handling method.

The substrate handling device 11 for handling a substrate 1 comprises a Bernoulli plate 13, several Bernoulli cups 13a, and a mechanical centering mechanism 14 comprising edge grippers 14a and at least a drive unit 14b. The edge grippers 14a are arranged along edges of the Bernoulli plate 13 to contact edges of the substrate 1 to grip the substrate 1. The drive unit 14b is arranged at a back side of the Bernoulli plate 13 and the drive unit 14b is configured to drive the edge grippers 14a relative to the Bernoulli plate 13 to position the substrate 1 relative to the Bernoulli plate 13. The Bernoulli cups 13a are distributed on a front side of the Bernoulli plate 13 and the Bernoulli cups 13a are configured to provide a local under pressure to hold the substrate 1 in a plane parallel to the Bernoulli plate 13.

## Description

### Technical field

The disclosure relates to a substrate handling device for handling a substrate, a substrate handling system, a use of the substrate handling device or the substrate handling system and a substrate handling method.

### Background

Substrate dimensions for producing electronic devices such as sensors, IC packages, printed circuit boards (PCBs), and screens are undergoing significant increases in their dimensions with progressing technology scaling in order to increase manufacturing efficiency as well as to accommodate the needed large size technology requirements. Substrates are already reaching single side lengths of significantly more than 1000 mm and in some cases even more than 3000 mm. However, the technical progress in microelectronics industry, followed by customer requests, is leading to a demand for even larger substrate sizes from year to year.

With increasing size of the substrates, handling procedures become more and more difficult as the risk of damaging the large sized substrates is increasing dramatically. Furthermore, with increasing substrate size, the costs for manufacturing are also rising. Therefore, a damage of a substrate leads to enormous economic losses.

Aside from the risks and technological challenges such as reaching a homogenous plating thickness and the request for faster plating/etching speed, with increasing substrate size, the handling of substrates has become more and more difficult due to increased weight and brittleness as a result of having thinner substrates. Major difficulties arise within the new processing/treatment technologies during handling of large substrates, where the substrates are positioned vertically during surface treatment, such as electroplating/de-plating or chemical deposition/etching.

The substrates to-be-treated are usually stored and transported in specialized plastic enclosures which can be defined as storage pods, also called Front Opening Unified Pod (FOUP). In such a FOUP, a substrate is entering the process line usually horizontally with a front side facing upwards and hence rear side facing downwards. In a vertical surface treatment, the substrates are positioned vertically during surface treatment. Accordingly, when the substrate is transported horizontally, the main task is to flip the substrate into a vertical position, also called vertical flip to fit it into a vertical process chamber.

In general, a substrate features two main sides: a front side and a rear side. The front side is usually the surface, which needs to be treated, e.g. by electroplating or chemically etching/deposition. Before being inserted into the vertical process chamber, the substrate has to be embedded into a special frame, a so-called chucking unit, with its rear side first, to let the front side, which is to-be-treated free. This front side mostly exhibits microscopic structures defining microelectronic features, which are very sensitive as they can be damaged very easily by physical contact, such as with tools. Hence, during handling of the substrates, i.e. vertical flip and embedding into the chucking unit, there has to be taken a special care of the substrate front side exhibiting sensitive structures.

The available substrate handling devices in the prior art usually comprise mechanical grippers that can only grip the substrate at the sides, where no sensitive structures are present (so-called exclusion zones). Yet, the increased size of the substrates leads the exclusion zones to become narrower, thus leading to a difficult handling of the substrates and possible damages by the mechanical contact to the substrates. Accordingly, for transportation and handling of substrates (especially the large ones with more than 500 mm side length) standard methods may not be suitable.

### Summary

Hence, there may be a need to provide an improved substrate handling device for handling a substrate, which provides a secure transportation and safe handling of a substrate.

The problem of the present disclosure is solved by the subject-matters of the independent claims, wherein further embodiments are incorporated in the dependent claims. It should be noted that the aspects of the disclosure described in the following apply also to the substrate handling device for handling a substrate, the substrate handling system, the use of the substrate handling device or the substrate handling system and the substrate handling method.

According to the present disclosure, a substrate handling device for handling a substrate is presented. The substrate handling device for handling a substrate comprises a Bernoulli plate, several Bernoulli cups, and a mechanical centering mechanism comprising edge grippers and at least a drive unit. The edge grippers are arranged along edges of the Bernoulli plate to contact edges of the substrate to grip the substrate. The drive unit is arranged at a back side of the Bernoulli plate and the drive unit is configured to drive the edge grippers relative to the Bernoulli plate to position the substrate relative to the Bernoulli plate. The Bernoulli cups are distributed on a front side (opposite to the back side) of the Bernoulli plate and the Bernoulli cups are configured to provide a local under pressure to hold the substrate in a plane parallel to the Bernoulli plate.

The substrate handling device may be used to pick up a substrate to be handled from one location and carry it to another (for instance to a treatment chamber). The substrate handling device may load the carried substrate to another unit for surface treatment or keep the substrate attached thereto throughout the treatment process. Accordingly, handling here may mean not only transportation but also transfer and/or withholding of the substrate before, during and as well as after a surface treatment.

The Bernoulli plate may be a flat plate preferably having at least a size of the substrate to-be-handled/treated. The function of the Bernoulli cups on the plate may be based on the Bernoulli effect. The Bernoulli Effect states that at a location where a gas flow (for instance air flow) is faster, the pressure is smaller compared to other regions where the gas flow is slower. Therefore, by special design of an interior of the Bernoulli cups for defined accelerated gas flow, it may be possible to generate a well-defined under pressure compared to ambient pressure. This under pressure may generate a holding force on the substrate to-be-carried.

The Bernoulli cups may be distributed on a front side of the Bernoulli plate homogenously. Accordingly, the Bernoulli plate may be configured to apply the same under pressure (holding force) throughout the plate. Alternatively, distribution of the Bernoulli cups may be uneven on the surface of the plate. For instance, more cups may be present at a central part than at the edges of the plate or vice-versa.

The mechanical centering mechanism comprises edge grippers and at least a drive unit that may move the edge grippers with respect to the plate. The drive unit and the edge grippers may position the substrate relative to the Bernoulli plate. The edge grippers may have the function of keeping the substrate in alignment with the Bernoulli cups to ensure application of the holding force, thereby holding of the substrate. The edge grippers may contact the edges of the substrate minimally because the substrate may be already held by the holding force of applied by the Bernoulli plate. The drive unit may automatize the centering process of the substrate to-be-handled with respect to the plate.

The plane in that a substrate to-be-handled is held parallel to the Bernoulli plate can be at a distance of 0, 1 to 2 mm, preferably 0,2 to 1 mm from the plate for optimal application of holding force. The distance may be selected to apply the optimal holding force on the substrate, such that, the substrate may be held via a force, which does not exceed a defined magnitude. Accordingly, the held substrate is prevented to be exposed to a holding force higher than required.

In an embodiment, the Bernoulli cups provide a contactless holding of the substrate by means of the local under pressure.

The under pressure created by the Bernoulli cups with respect to the ambient pressure may provide a suction-like force, allowing the substrate handling device to hold the substrate to-be-handled in a contactless manner. As mentioned before, the local under pressure can be created by a flow, which has a higher velocity than neighboring gas molecules. Larger substrates can be heavier. Accordingly, for larger substrates, a higher holding force may be needed. The main advantage of contactless handling may be that holding of a substrate is not limited to the mechanical contact of the edge grippers, for instance at the exclusion zones of the substrate, but that the holding force can be applied to almost the entire surface of the substrate to-be-handled by virtue of the contactless holding of the cups. Further, any damage to the sensitive surface structures on the substrate to-be-handled by, for instance, a mechanical attachment can be avoided.

In an embodiment, the Bernoulli cups may be configured to adjust a velocity of the applied flow, thereby adjusting a magnitude of the under-pressure (thereby the holding force applied to the substrate). The magnitude may be adjusted for instance when the substrate to be handled does not have a homogenous weight distribution. This can be the case when surface structures are collected at a particular surface portion of the substrate. The flow velocity may be controlled independently for each cup, thereby providing a more accurate local adjustment of the applied holding force.

In an embodiment, the substrate handling device for handling a substrate further comprises a gas supply inlet to provide a gas flow within the Bernoulli cups to implement the local under pressure in the Bernoulli cups. The substrate handling device may further comprise a gas supply connected to the gas supply inlet. By providing the Bernoulli Effect through the gas supply via gas supply inlet, it is possible to use an external gas source. Therefore, the substrate handling device does not have to get heavier with a higher volume by having a gas supply arrangement with the gas supply and inlet being inside the device.

In an embodiment, the Bernoulli cups are configured to provide a local flattening of the substrate by means of the local under pressure. Here, flattening means local de-buckling or straightening of the substrate, namely preventing deformities (e.g. bulges or dents) on the surface of the substrate. The surface is flattened to be planar. Local flattening of the substrate due to the locally distributed cups of the Bernoulli plate may lead to a high degree overall flattening and hence flat or planar substrates. The local flattening of sub-areas of a large substrate may further reduce mechanical stresses acting thereon.

As in one of the previously mentioned embodiments, the Bernoulli cups may be configured to adjust a velocity of the air flow to adjust the applied holding force (in other words suction force emerging from under pressure). Adjusting the magnitude of the applied under-pressure onto the substrate may provide a more sensitive flattening process depending on the needed force at local level. For instance, at parts of the substrate where the deformation is at a higher level, a stronger flattening may be necessary. Accordingly, at these portions the cups may be configured to provide a higher gas flow. In this embodiment, the flow velocity may be controlled independently in each cup, thereby providing a more accurate local adjustment of flattening the substrate.

In an embodiment, the mechanical centering mechanism and the Bernoulli cups provide a holding of the substrate in a vertical position. Of course, the mechanical centering mechanism and the Bernoulli cups may also hold the substrate in a horizontal or any other position.

For the most accurate surface handling of a substrate, the positive effects of vertical handling has been proven. It is of utmost importance that during vertical handling the substrate to-be-handled can be held safely. For this application, usage of Bernoulli cups brings a particular advantage. For vertical processing, it is not suggested to use an optical centering mechanism (in other words using basic human vision) because of its low accuracy in the positioning of the substrate. Because it is more difficult to position the vertically arranged substrate accurately, a mechanical centering mechanism is of great advantage. Accordingly, combining the Bernoulli cups with the mechanical centering mechanism provides a more precise positioning of the substrate to-be-handled.

In an embodiment, the mechanical centering mechanism comprises at least four edge grippers, each provided at one edge of the Bernoulli plate to hold one edge of the substrate. The edge grippers may at least hold the substrate still attached to the substrate handling device in case the Bernoulli cups stop applying a holding force to the substrate. The edge grippers may thus provide an additional safety precaution against detaching of the substrate from the device.

Each edge gripper may be movably (such as slidably) mounted on a track. The position of each edge gripper may be adjustable on the tracks independent of each other. The positioning of the edge grippers may be controlled automatically by the drive unit as well as by hand.

According to the present disclosure, also a substrate handling system is presented. The substrate handling system comprises a substrate handling device as described above and a chucking unit. The substrate handling device and the chucking unit are moveable relative to each other to hand over a substrate to the chucking unit. The chucking unit comprises fixing elements to fix the substrate during a chemical and/or electrolytic treatment of the substrate.

The substrate handling device may be moveable relative to the chucking unit to transfer the substrate to-be treated onto the chucking unit, where the substrate may be further handled, for instance, in a surface treatment process. The substrate handling device may ensure a safe holding and transportation of the substrate to hand over to the chucking unit. Thereafter, the substrate may be fixed into the chucking unit through conventional fixing elements such as fasteners like screws and bolts, as well as unconventional fixing elements such as magnets or another Bernoulli plate.

The chucking unit may have at least one of the following purposes:
- macroscopically straightening the substrate to-be-treated to avoid buckling due to gravity and/or residual stresses from previous processes,
- inserting the substrate to-be-treated into a process chamber in a controlled way to avoid damage of the substrate by contacting a process chamber wall,
- holding the substrate to-be-treated at a defined position without any damage for instance during a surface treatment process inside the process chamber,
- in an electroplating/de-plating process, electrically contacting the substrate, preferably from a seed layer, in order to enable electric current flow between an anode and a cathode.

Inserting a substrate to-be-treated into the chucking unit is called "Bernoulli handshake". During the Bernoulli handshake, it is important to align the substrate with the chucking unit to ensure an optimum electrical contact therebetween. Thus, in this embodiment, the mechanical centering mechanism of the substrate handling device may be configured to center the substrate to the chucking unit, optionally from four sides by the edge grippers. The position of the substrate may be adjusted by moving linearly on the tracks. Alternatively, the substrate handling system may comprise additionally a drive unit for automatic adjustment of the position of the substrate with respect to the chucking unit. Accordingly, the coordinates of a center point of the substrate may be adjusted accurately with respect to a center of the chucking unit by mechanical or electronic means. This may provide a well-defined positioning of the substrate leading to an optimum electrical contact (for instance, equally at all four sides of the substrate) after being placed in the chucking unit.

The Bernoulli cups that are configured to provide a local flattening of the substrate by means of the local under pressure are especially important for large substrates. The Bernoulli cups, which may be distributed in a certain pattern on the Bernoulli plate may provide a local straightening of the substrate in an area at and around the cups. The local straightening may add up from one cup to the next leading to an overall adequately flat substrate. The local straightening of sub-areas of a large substrate may generate reduced mechanical stresses acting on the substrate by reaching an improved flatness at the same time.

In an embodiment, the fixing elements are configured to macroscopically straighten the substrate. Macroscopical straightening means an at once overall straightening of the substrate at a macroscopical level. The macroscopical straightening may be performed through pulling and/or pushing of the substrate edges by the fixing elements. This can be seen as an additional step of straightening of the substrate to-be-treated to obtain optimal flat surface for accurate alignment of the surface structures to-be-treated with the chucking unit. With this, processing results such as electroplating/de-plating can be improved significantly.

In an embodiment, the chucking unit comprises electric contact elements to electrically contact the substrate to enable an electric current flow relative to the substrate. Alignment of the substrate to-be-treated with the electric contact elements of the chucking unit becomes once more significant in this embodiment. An incorrect positioning and thus alignment of the substrate with the electric contact elements may lead to false surface treatment, for instance plating of an exclusion zone of a substrate.

In an embodiment, the substrate handling device is positioned on a first side of the chucking unit, and the substrate handling system further comprises another substrate handling device, which is positioned on a second side of the chucking unit opposite to the first side. The substrates may be transferred by the "Bernoulli handshake" process and then be inserted into the chucking unit. The substrate handling devices may be positioned parallel or angled with respect to each other. The surfaces of the substrates which are not to-be-treated (rear or back sides) may face each other and the opposite surfaces to-be-treated (front sides) may face outwards for subsequent processing. It is however also possible to have structures to-be-treated on both front and rear/back sides. The Bernoulli cups may allow a safe holding of a substrate independent of the held surface. In this embodiment, two substrates may be transported and handled simultaneously.

According to the present disclosure, also a use of the substrate handling device or the substrate handling system for handling a substrate is presented. The substrate may have a side length of at least 1000 mm. The substrate handling device may be particularly suitable for using with large substrates having a side length of at least 1000 mm because of the security and safety provided during transportation and handling.

According to the present disclosure, also a substrate handling method is presented. The substrate handling method comprises the following steps, not necessarily in this order:
- providing a Bernoulli plate with several Bernoulli cups distributed on a front side of the Bernoulli plate,
- providing a mechanical centering mechanism comprising edge grippers and at least a drive unit, wherein the edge grippers are arranged along edges of the Bernoulli plate and the drive unit is arranged at a back side of the Bernoulli plate,
- gripping edges of a substrate by means of the edge grippers, driving the edge grippers by means of the drive unit relative to the Bernoulli plate to position the substrate relative to the Bernoulli plate, and
- providing a local under pressure by means of the Bernoulli cups to hold the substrate in a plane parallel to the Bernoulli plate.

The substrate handling method may provide a safe transportation and handling of a substrate to-be-processed.

The substrate handling method may be used to pick up a substrate to be handled from one location and carry it to another (for instance to a treatment chamber). Handling here may mean not only transportation but also transfer and/or withholding of the substrate.

The Bernoulli plate may be a flat plate preferably having at least a size of the substrate to-be-handled/treated. The function of the Bernoulli cups on the plate may be based on the well-known Bernoulli effect. The Bernoulli Effect states that at a location where a gas flow (for instance air flow) is faster, the pressure is smaller compared to other regions where the gas flow is slower. Therefore, by special design of an interior of the Bernoulli cups for defined accelerated gas flow, it may be possible to generate a well-defined under pressure compared to ambient pressure. This under pressure may generate a holding force.

The mechanical centering mechanism comprises edge grippers and at least a drive unit that moves the edge grippers with respect to the plate. Accordingly, edge grippers may have the function of keeping the substrate in alignment with the Bernoulli cups to ensure application of the holding force, thereby holding of the substrate. The drive unit may automatize the centering process of the substrate to-be-handled with respect to, for instance the plate. The edge grippers may contact the edges of the substrate minimally because the substrate may be already held by the Bernoulli plate.

In an embodiment, the local under pressure of the Bernoulli cups contacts the substrate on a front surface of the substrate, which contains electronic structures.

The local under pressure created by the Bernoulli cups with respect to the ambient pressure may provide a suction-like force, allowing the substrate to be contacted in an almost contactless manner. Accordingly, contacting of the substrate via the local under pressure of the cups here may not be defined as a conventional contacting. The contact pressure of the Bernoulli cups may be much less than a mechanical contact for holding a substrate. Because the contact has much less disturbance to the substrate, holding of the substrate may be applied to almost the entire surface of the substrate to-be-handled.

In an embodiment, the substrate handling method further comprises a removing of the substrate from a storage pod by means of a robot and a taking over the substrate from the robot by means of a substrate handling device comprising the gripping edges and the Bernoulli cups.

In an embodiment, the substrate handling method further comprises a flipping of the substrate into a vertical position. This may be required for the conventional production practices, in which the substrate to-be-treated is delivered on a horizontal production line. For vertical treatment, the substrate may be flipped to a vertical position. However, an initially vertically positioned substrate may be handled and treated in the vertical position without needing to be flipped.

In an embodiment, the substrate handling method further comprises handling the substrate over to a chucking unit, wherein the chucking unit contacts a back surface of the substrate opposite to the front surface.

The substrate held by the Bernoulli cups from the front surface, while being transferred into the chucking unit, may face the chucking unit with a rear side. This may allow the front side of the substrate to face outwards (free for further handling) after hand over to the chucking unit. After hand over, the chucking unit may then hold the substrate at its rear side. With this arrangement, the substrate may be ready for treatment at its front side, without flipping.

It shall be understood that the system, the device, the use, and the method according to the independent claims have similar and/or identical preferred embodiments, in particular, as defined in the dependent claims. It shall be understood further that a preferred embodiment of the disclosure can also be any combination of the dependent claims with the respective independent claim.

These and other aspects of the present disclosure will become apparent from and be elucidated with reference to the embodiments described hereinafter.

### Brief description of the drawings

Exemplary embodiments of the disclosure will be described in the following with reference to the accompanying drawing:
- Figure 1: shows schematically and exemplarily an embodiment of a substrate handling system according to the disclosure.
- Figure 2: shows schematically and exemplarily another embodiment of a substrate handling system according to the disclosure.
- Figure 3: shows schematically and exemplarily another embodiment of the substrate handling system of Figure 2 according to the disclosure.
- Figure 4: shows schematically and exemplarily an embodiment of a substrate handling device for handling a substrate according to the disclosure.
- Figure 5: shows schematically and exemplarily an embodiment of a substrate handling device for handling a substrate according to the disclosure from another perspective.
- Figure 6: shows schematically and exemplarily a substrate handling method according to the disclosure.

### Detailed description of embodiments

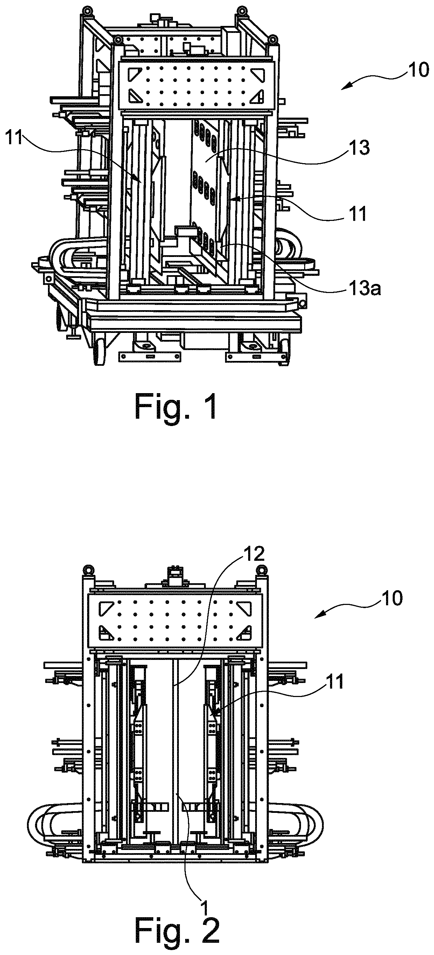

**Figure 1** shows schematically and exemplarily an embodiment of a substrate handling system 10 according to the disclosure. The substrate handling system 10 comprises two substrate handling devices 11. The chucking unit 12 has been excluded from this figure for simplicity. The substrate handling device 11 for handling a substrate 1 comprises a Bernoulli plate 13, several Bernoulli cups 13a, and a mechanical centering mechanism 14 comprising edge grippers 14a and at least a drive unit 14b (not shown in Figure 1). The Bernoulli cups 13a are distributed on a front side of the Bernoulli plate 13. The Bernoulli cups 13a are configured to provide a local under pressure to hold the substrate 1 (not shown in Fig. 1) in a plane parallel to the Bernoulli plate 13.

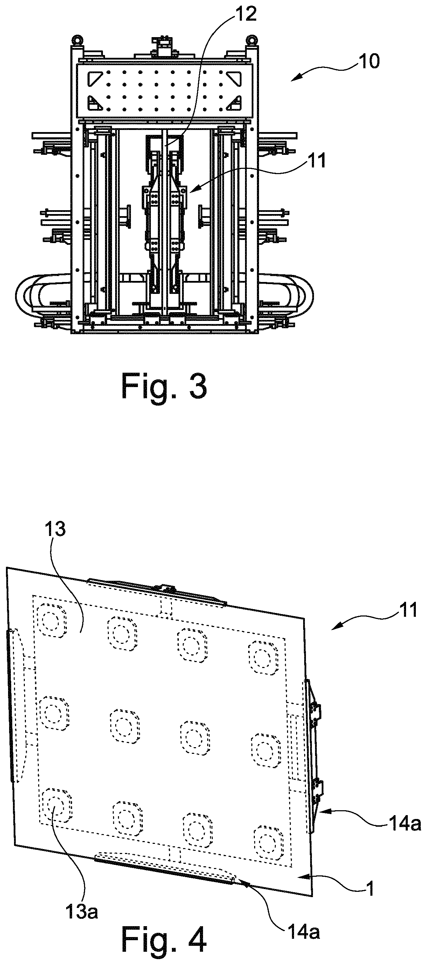

**Figures 2** **and** **3** show schematically and exemplarily other embodiments of the substrate handling system 10 according to the disclosure. The substrate handling system 10 comprises a chucking unit 12 between the substrate handling devices 11. The substrate handling devices 11 and the chucking unit 12 are moveable relative to each other to hand over the substrate 1 to the chucking unit 12. Figure 3 shows the handed over status of the substrate 1 on the chucking unit 12. The chucking unit 12 comprises fixing elements (not shown) to fix the substrate 1 during a chemical and/or electrolytic treatment of the substrate 1.

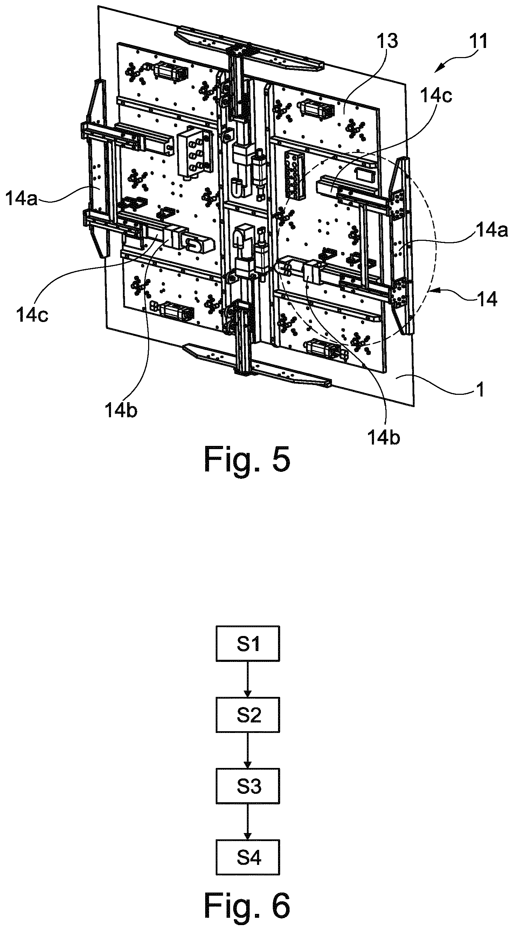

**Figures 4** **and** **5** show an embodiment of a substrate handling device 11 for handling a substrate 1 according to the disclosure. The Bernoulli plate 13 of this embodiment is a flat plate. The Bernoulli cups 13a are distributed on the plate 13 homogenously. Accordingly, the Bernoulli plate 13 is here configured to apply a distributed holding force throughout the Bernoulli plate 13. The edge grippers 14a are arranged along edges of the Bernoulli plate 13 to contact the edges of the substrate 1.

**Figure 5** shows the substrate handling device 11 from a back side. The mechanical centering mechanism 14 comprises edge grippers 14a and at least a drive unit 14b. The drive 14b unit is arranged at a back side of the Bernoulli plate 13 and is configured to drive the edge grippers 14a on the tracks 14c relative to the Bernoulli plate 13 to position the substrate 1. In this embodiment, the mechanical centering mechanism 14 comprises four edge grippers 14a, each provided at one edge of the Bernoulli plate 13 to hold one edge of the substrate 1.

**Figure 6** shows schematically and exemplarily a substrate handling method according to the disclosure. The substrate handling method comprises in a step S1 providing a Bernoulli plate 13 with several Bernoulli cups 13a distributed on a front side of the Bernoulli plate 13. In a step S2, a mechanical centering mechanism 14 is provided, which comprises edge grippers 14a and at least a drive unit 14b. The edge grippers 14a are arranged along edges of the Bernoulli plate 13 and the drive unit 14b is arranged at a back side of the Bernoulli plate 13. In a step S3, the edge grippers 14a are gripping the edges of a substrate 1. The drive unit 14b is driving the edge grippers 14a relative to the Bernoulli plate 13 in a next step S4 to position the substrate 1 relative to the Bernoulli plate 13. Further, in step S4 a local under pressure is provided by means of the Bernoulli cups 13a to hold the substrate 1 in a plane parallel to the Bernoulli plate 13.

It has to be noted that embodiments of the disclosure are described with reference to different subject matters. In particular, some embodiments are described with reference to method type claims whereas other embodiments are described with reference to the device type claims. However, a person skilled in the art will gather from the above and the following description that, unless otherwise notified, in addition to any combination of features belonging to one type of subject matter also any combination between features relating to different subject matters is considered to be disclosed with this application. However, all features can be combined providing synergetic effects that are more than the simple summation of the features.

While the disclosure has been illustrated and described in detail in the drawings and foregoing description, such illustration and description are to be considered illustrative or exemplary and not restrictive. The disclosure is not limited to the disclosed embodiments. Other variations to the disclosed embodiments can be understood and effected by those skilled in the art in practicing a claimed disclosure, from a study of the drawings, the disclosure, and the dependent claims.

In the claims, the word "comprising" does not exclude other elements or steps, and the indefinite article "a" or "an" does not exclude a plurality. A single processor or other unit may fulfil the functions of several items re-cited in the claims. The mere fact that certain measures are re-cited in mutually different dependent claims does not indicate that a combination of these measures cannot be used to advantage. Any reference signs in the claims should not be construed as limiting the scope.

## Claims

1. A substrate handling device (11) for handling a substrate (1), comprising:
- a Bernoulli plate (13),
- several Bernoulli cups (13a), and
- a mechanical centering mechanism (14) comprising edge grippers (14a) and at least a drive unit (14b),
wherein the edge grippers (14a) are arranged along edges of the Bernoulli plate (13) to contact edges of the substrate (1) to grip the substrate (1),
wherein the drive unit (14b) is arranged at a back side of the Bernoulli plate (13),
wherein the drive unit (14b) is configured to drive the edge grippers (14a) relative to the Bernoulli plate (13) to position the substrate (1) relative to the Bernoulli plate (13), and
wherein the Bernoulli cups (13a) are distributed on a front side of the Bernoulli plate (13), and
wherein the Bernoulli cups (13a) are configured to provide a local under pressure to hold the substrate (1) in a plane parallel to the Bernoulli plate (13).

2. Substrate handling device (11) according to claim 1, wherein the Bernoulli cups (13a) provide a contactless holding of the substrate (1) by means of the local under pressure.

3. Substrate handling device (11) according to one of the preceding claims, further comprising a gas supply inlet to provide a gas flow within the Bernoulli cups (13a) to implement the local under pressure in the Bernoulli cups (13a).

4. Substrate handling device (11) according to one of the preceding claims, wherein the Bernoulli cups (13a) are configured to provide a local flattening of the substrate (1) by means of the local under pressure.

5. Substrate handling device (11) according to one of the preceding claims, wherein the mechanical centering mechanism (14) and the Bernoulli cups (13a) provide a holding of the substrate (1) in a vertical position.

6. Substrate handling device (11) according to one of the preceding claims, wherein the mechanical centering mechanism (14) comprises at least four edge grippers (14a), each provided at one edge of the Bernoulli plate (13) to hold one edge of the substrate (1).

7. A substrate handling system (10), comprising:
- a substrate handling device (11) according to one of the preceding claims, and
- a chucking unit (12),
wherein the substrate handling device (11) and the chucking unit (12), are moveable relative to each other to hand over a substrate (1) from the substrate handling device (11) to the chucking unit (12), and
wherein the chucking unit (12), comprises fixing elements to fix the substrate (1) during a chemical and/or electrolytic treatment of the substrate (1).

8. Substrate handling system (10) according to the preceding claim, wherein the fixing elements are configured to macroscopically straighten the substrate (1).

9. Substrate handling system (10) according to one of the preceding claims, wherein the chucking unit (12), comprises electric contact elements to electrically contact the substrate (1) to enable an electric current flow relative to the substrate (1).

10. Substrate handling system (10) according to one of the preceding claims, wherein the substrate handling device (11) is positioned on a first side of the chucking unit (12), and wherein the substrate handling system (10) further comprises another substrate handling device (11), which is positioned on a second side of the chucking unit (12) opposite to the first side.

11. A use of the substrate handling device (11) or the substrate handling system (10) according to one of the preceding claims for handling a substrate (1) with a side length of at least 1000 mm, preferably at least 2000 mm, more preferably at least 3000 mm.

12. A substrate handling method, comprising:
- providing a Bernoulli plate (13) with several Bernoulli cups (13a) distributed on a front side of the Bernoulli plate (13),
- providing a mechanical centering mechanism (14) comprising edge grippers (14a) and at least a drive unit (14b), wherein the edge grippers (14a) are arranged along edges of the Bernoulli plate (13) and the drive unit (14b) is arranged at a back side of the Bernoulli plate (13),
- gripping edges of a substrate (1) by means of the edge grippers (14a),
- driving the edge grippers (14a) by means of the drive unit (14b) relative to the Bernoulli plate (13) to position the substrate (1) relative to the Bernoulli plate (13), and
- providing a local under pressure by means of the Bernoulli cups (13a) to hold the substrate (1) in a plane parallel to the Bernoulli plate (13).

13. Substrate handling method according to the preceding claim, wherein the local under pressure of the Bernoulli cups (13a) contacts the substrate (1) on a front surface of the substrate (1), which contains electronic structures.

14. Substrate handling method according to one of the preceding claims, further comprising a removing of the substrate (1) from a storage pod by means of a robot and a taking over the substrate (1) from the robot by means of a substrate handling device (11) comprising the gripping edges and the Bernoulli cups (13a).

15. Substrate handling method according to one of the preceding claims, further comprising a flipping of the substrate (1) into a vertical position.

16. Substrate handling method according to one of the preceding claims, further comprising a handling the substrate (1) over to a chucking unit (12), wherein the chucking unit (12) contacts a back surface of the substrate (1) opposite to the front surface.

## Amended claims

### Amended claims in accordance with Rule 137(2) EPC.

1. A substrate handling device (11) for handling a substrate (1), comprising:
- a Bernoulli plate (13),
- several Bernoulli cups (13a), and
- a mechanical centering mechanism (14) comprising edge grippers (14a) and at least a drive unit (14b),
wherein the edge grippers (14a) are arranged along edges of the Bernoulli plate (13) to contact edges of the substrate (1) to grip the substrate (1),
wherein the drive unit (14b) is arranged at a back side of the Bernoulli plate (13),
wherein the drive unit (14b) is configured to drive the edge grippers (14a) relative to the Bernoulli plate (13) to position the substrate (1) relative to the Bernoulli plate (13),
wherein the Bernoulli cups (13a) are distributed on a front side of the Bernoulli plate (13), and
wherein the Bernoulli cups (13a) are configured to provide a local under pressure to hold the substrate (1) in a plane parallel to the Bernoulli plate (13),
**characterized in that** the Bernoulli cups (13a) are configured to provide a local flattening of the substrate (1) by means of the local under pressure.

2. Substrate handling device (11) according to claim 1, wherein the Bernoulli cups (13a) provide a contactless holding of the substrate (1) by means of the local under pressure.

3. Substrate handling device (11) according to one of the preceding claims, further comprising a gas supply inlet to provide a gas flow within the Bernoulli cups (13a) to implement the local under pressure in the Bernoulli cups (13a).

4. Substrate handling device (11) according to one of the preceding claims, wherein the mechanical centering mechanism (14) and the Bernoulli cups (13a) provide a holding of the substrate (1) in a vertical position.

5. Substrate handling device (11) according to one of the preceding claims, wherein the mechanical centering mechanism (14) comprises at least four edge grippers (14a), each provided at one edge of the Bernoulli plate (13) to hold one edge of the substrate (1).

6. A substrate handling system (10), comprising:
- a substrate handling device (11) according to one of the preceding claims, and
- a chucking unit (12),
wherein the substrate handling device (11) and the chucking unit (12), are moveable relative to each other to hand over a substrate (1) from the substrate handling device (11) to the chucking unit (12), and
wherein the chucking unit (12), comprises fixing elements to fix the substrate (1) during a chemical and/or electrolytic treatment of the substrate (1).

7. Substrate handling system (10) according to the preceding claim, wherein the fixing elements are configured to macroscopically straighten the substrate (1).

8. Substrate handling system (10) according to one of the preceding claims, wherein the chucking unit (12), comprises electric contact elements to electrically contact the substrate (1) to enable an electric current flow relative to the substrate (1).

9. Substrate handling system (10) according to one of the preceding claims, wherein the substrate handling device (11) is positioned on a first side of the chucking unit (12), and wherein the substrate handling system (10) further comprises another substrate handling device (11), which is positioned on a second side of the chucking unit (12) opposite to the first side.

10. A use of the substrate handling device (11) or the substrate handling system (10) according to one of the preceding claims for handling a substrate (1) with a side length of at least 1000 mm, preferably at least 2000 mm, more preferably at least 3000 mm.

11. A substrate handling method, comprising:
- providing a Bernoulli plate (13) with several Bernoulli cups (13a) distributed on a front side of the Bernoulli plate (13),
- providing a mechanical centering mechanism (14) comprising edge grippers (14a) and at least a drive unit (14b), wherein the edge grippers (14a) are arranged along edges of the Bernoulli plate (13) and the drive unit (14b) is arranged at a back side of the Bernoulli plate (13),
- gripping edges of a substrate (1) by means of the edge grippers (14a),
- driving the edge grippers (14a) by means of the drive unit (14b) relative to the Bernoulli plate (13) to position the substrate (1) relative to the Bernoulli plate (13), and
- providing a local under pressure by means of the Bernoulli cups (13a) to hold the substrate (1) in a plane parallel to the Bernoulli plate (13),
**characterized in that** the Bernoulli cups (13a) are further configured to provide a local flattening of the substrate (1) by means of the local under pressure.

12. Substrate handling method according to the preceding claim, wherein the local under pressure of the Bernoulli cups (13a) contacts the substrate (1) on a front surface of the substrate (1), which contains electronic structures.

13. Substrate handling method according to one of the preceding claims, further comprising a removing of the substrate (1) from a storage pod by means of a robot and a taking over the substrate (1) from the robot by means of a substrate handling device (11) comprising the gripping edges and the Bernoulli cups (13a).

14. Substrate handling method according to one of the preceding claims, further comprising a flipping of the substrate (1) into a vertical position.

15. Substrate handling method according to one of the preceding claims, further comprising a handling the substrate (1) over to a chucking unit (12), wherein the chucking unit (12) contacts a back surface of the substrate (1) opposite to the front surface.
